# EUROPEAN PATENT APPLICATION

(11) **EP 4 318 604 A1**
(43) Date of publication of application: **07.02.2024**
(21) Application number: 23189841.2
(22) Date of filing: 04.08.2023
(51) Int. Cl.: H01L 31/0465, H01L 31/0224

(54) **THIN FILM PHOTOVOLTAIC DEVICES AND METHOD OF MANUFACTURING THEM**

(30) Priority: 04.08.2022 IT 202200016755
(71) Applicant: Solertix Srl, 00147 Roma (IT)
(72) Inventor: DI GIACOMO, Francesco, 00147 Rome (IT)
(74) Representative: Banchetti, Marina

(57) **Abstract**

The invention concerns thin film photovoltaic devices, containing a substrate, a first transparent conductive electrode, an absorber of electromagnetic radiation between two selective semiconductors and a second conductive electrode which form the final structure of the device. The limited conductivity of transparent electrodes represents a limitation in the design of large-area thin-film photovoltaic devices.

The present invention teaches the deposition of one or two metal supporting electrodes (8) on the side of the cell not directly exposed to light, using insulating layers (7) which prevent direct contact between the electrodes (4, 6) and the absorbing layer (5), and allows the supporting electrodes (8) to be overlapped for minimizing shading, if required. The manufacturing scheme of the photovoltaic device with one or two supporting electrodes (8) represents a technological advancement to enlarge the size of large area cells, decrease the shading provided by the collection grids and provide a new interconnection scheme that can mitigate some degradation mechanisms.

## Description

### Field of the invention

The present invention concerns thin film photovoltaic (PV) devices and a method of manufacturing them. More specifically, the invention concerns thin film photovoltaic devices containing a substrate, a conductive electrode, an absorber of electromagnetic radiation between two selective semiconductors and a second conductive electrode, arranged in overlapping layers to form the final structure of the device.

### Background of the invention

It is known that a solar cell or photovoltaic cell is a solid-state device (semiconductor) that converts the energy of incident sunlight directly into electricity via the photovoltaic effect. Thin film solar cell technology was developed to minimize material use. While conventional solar cells are based on monocrystalline or polycrystalline silicon, whose wafers can reach a thickness of 200 µm, thin film solar cells are obtained by sequentially depositing thin layers of electrodes (of which at least one is transparent) and photovoltaic material on a substrate, such as glass, plastic or metal, and typically have a thickness between a few nanometers and a few microns. Amorphous silicon (a-Si), cadmium telluride (CdTe), copper indium gallium selenide (CIGS), and gallium arsenide (GaAs) are significant types of solar thin films that have dominated the solar thin film market so far. In addition, new generations of solar thin films with different materials (e.g. based on perovskites) have been rapidly developed in recent years to address various challenges, such as production costs, long-term stability, environmental issues and increasing efficiency.

Large area thin film PV devices are based on a monolithic series interconnection of multiple thin film cells of limited area, a necessary measure to limit the current in the device and avoid the resistive loss associated with it (Perrenoud, J. et al., Fabrication of flexible CdTe solar modules with monolithic cell interconnection. Sol. Energy Mater. Sol. Cells 95, S8-S12 (2011); Matteocci, F. et al., High efficiency photovoltaic module based on mesoscopic organometal halide perovskite. Prog. Photovoltaics Res. Appl. 24, 436-445 (2016); Gupta, Y. et al., Optimization of a-Si solar cell current collection, in Conference Record of the IEEE Photovoltaic Specialists Conference 1092-1101 (1982)). The limit on the size of single cells is mainly due to the low conductivity of the transparent electrode, which sets a practical limit on cell width within a range of a few millimeters. This aspect is critical, in particular, in the case where both electrodes are transparent, as in semi-transparent or bifacial devices.

The series interconnections between one cell and another are created during the deposition of the various layers. The most common method used to create these interconnections is called the P1-P2-P3 process, represented by three subsequent linear incisions generally made with laser ablation. The P1 process, which is carried out when only the layer corresponding to the lower electrode has been deposited on the substrate, isolates the lower electrode of the adjacent cells. During the P2 process, which is carried out after the deposition of the layer of photovoltaic material (including the intermediate, upper and lower carrier layers), the ablation selectively removes a linear portion, slightly spaced from the P1 line, of the photovoltaic material. The P2 process is performed to create an electrical contact between the lower and upper conductive layers and to achieve current flow between adjacent cells. Finally, the P3 process is carried out on a line slightly distant from the P2 line, and serves to separate a single cell from the adjacent one.

The surface of the resulting module is thus made up of active zones, which are dedicated to the photogeneration of electrical charges and the conversion of photovoltaic energy, and dead zones, dedicated to the interconnection between adjacent cells. Specifically, the dead zone of a cell is made up of zones P1, P2 and P3 and of two safety areas interposed between them.

The classic P1 P2 P3 monolithic interconnection (Heise, G. et al., Demonstration of the monolithic interconnection on CIS solar cells by picosecond laser structuring on 30 by 30 cm 2 modules, Prog. Photovoltaics Res. Appl. 23, 1291-1304 (2015)) shows limitations when the light absorbing materials are not chemically inert. Actually, the P2 structure creates a region in which there is direct contact between the light absorbing layer and the upper electrode, giving rise to a possible mechanism of chemical degradation (Bi, E. et al. Efficient Perovskite Solar Cell Modules with High Stability Enabled by Iodide Diffusion Barriers, 2748-2760 doi:10.1016/j.joule.2019.07.030). The same can also happen in the P3 structure, which creates contact between the materials used in the device and the external coating material (encapsulant).

In order to avoid the need for monolithic interconnections or reduce the number of interconnections, thus reducing resistive losses due to cells with a larger surface area, it is possible to use a supporting electrode (i.e. a metal grid) to increase the conductivity of the transparent electrode while still maintaining a good level of transparency. This is also the most common approach in the fabrication of silicon solar cells (Ebong, A. & Chen, N., Metallization of crystalline silicon solar cells: A review. in High Capacity Optical Networks and Emerging/Enabling Technologies 102-109 (IEEE, 2012). doi:10.1 109/HONET.2012. 6421444). Some examples of implementing metal grids on the top electrodes have been reported for organic thin-layer PV cells (Galagan, Y. et al. Scaling Up ITO-Free Solar Cells. Adv. Energy Mater. 4, 1300498 (2014)).

However, in thin film solar cells this approach is only useful when the transparent electrode is the upper one, as it is not practical to add a grid to the lower electrode, which is between the substrate and the light absorbing layer. In fact, to reach the lower electrode it would be necessary to forego depositing the active layers in the areas where the grid should be deposited, thus further complicating the manufacturing process and reducing the active area of the device. A different way to add a grid to the bottom electrode is to embed the grid under the transparent electrode, i.e. in the substrate. This is only feasible in the case of flexible substrates, for which methods are available to embed grids in the substrate, for example by using UV-curable polymers and metal grids (Kim, D. J. et al., High aspect ratio silver grid transparent electrodes using UV embossing process. AIP Adv. 7, 105218 (2017). Furthermore, in this case (as for silicon cells), the grid is located on the side that is oriented towards the light source, thus reducing the light falling on the absorbing layers.

In silicon cells it is possible to mitigate this effect with the Metallization Wrap Through technology, which requires the formation of contacts passing through the cell itself, to position a large part of the grids on the lower side of the device, even if in contact with the upper side (Benjamin, T. et al. The Path to Industrial Production of Highly Efficient Metal Wrap Through Silicon Solar Cells. GREEN 2, (2012)). A similar approach cannot be transferred directly to thin film PV devices due to the high thickness of the substrates used (for example glass) and the lack of an insulation layer, which in Metallization Wrap Through cells is obtained by forming a silicon oxide layer thermally.

In the field of thin film PV devices, various alternative solutions have been proposed by the prior art to connect two cells in series using electrical connections between layers (via-holes). For example, the European patent application EP2511961 of LG Innotek Co., Ltd. (corresponding to the international patent application published with No. WO2012/015150) discloses a method for interconnecting two adjacent thin film cells through an additional conducting layer for each cell, which layer connects the top electrode of one cell with the bottom electrode of the adjacent cell.

More recently, Truwin Opto-Electronics Limited patent US11309445 (corresponding to international patent application published with No. WO2020/237697) proposed a thin film PV device specifically usable for display modules with a transparent substrate, designed for wearable electronic devices. The device is equipped with auxiliary electrodes that contact a transparent front electrode ("front" when in use, i.e. in the direction of solar radiation entry) by means of via holes.

### Summary of the invention

The present invention allows to solve the problem of accessing the lower electrode to add one or two supporting electrodes, which can be used both in opaque thin film devices and in semi-transparent or bifacial thin film devices. Thanks to the present invention, it is possible to expand significantly the dimensions of thin film photovoltaic cells, and especially of semi-transparent or bifacial thin film PV cells: this drastically reduces the voltage of the resulting module, making it compatible with conventional inverters and reducing the maximum reverse bias.

The invention consists in using a via-hole contact protected by an insulating layer for the supporting electrode in contact with the lower electrode, and preferably using an open structure of the insulating layer to deposit a second supporting electrode. This results in an innovative interconnection scheme, which uses supporting electrodes instead of a standard P2 contact.

According to the present invention, a first metal supporting electrode is added to a conventional thin film photovoltaic device structure, i.e. a structure where each cell is formed by depositing on a substrate transparent to solar radiation a transparent conductive electrode, then an absorber of electromagnetic radiation between two layers of selective semiconductors and a second conductive electrode, preferably also transparent, said first metal supporting electrode being in contact with the lower electrode through a series of via-holes distributed on the PV device area.

Preferably, this solution is also made compatible with semi-transparent devices, which could be used for example in four-terminal tandem structures. This last type of device normally uses two transparent electrodes, which can suffer high resistive losses, and in which the use of two metal grids could cause significant losses of transparency. The present invention allows the loss of transparency due to the presence of two supporting electrodes to be mitigated, first of all due to the fact that these supporting electrodes are on the back side of the cells. Secondly, the invention also provides a design in which such two supporting electrodes can be largely overlapped. Compared to a standard interconnection method, the via hole and interconnection scheme are structured to prevent any possible chemical degradation of the light-absorbing material, preventing any contact of the latter with the supporting electrode, with the upper electrode or with the encapsulation material.

The manufacture of the via hole requires the opening of a passage, the deposition of an insulating material and the deposition of the supporting electrode. The manufacturing techniques that can be used for the via hole are, by way of example but not exclusively, a selective deposition of all the layers (e.g. by inkjet printing, screen printing, flexography) to avoid the deposition of the layers in the area of the via hole. As an alternative, a deposition over the entire area may be performed (e.g. by spin coating, blade coating, slot die coating, thermal evaporation, sputtering, chemical vapor deposition, atomic layer deposition, close space sublimation, pulsed laser deposition), followed by local ablations of the layers (e.g. by laser or mechanical ablation) in the areas of the via holes.

The deposition techniques that can be used for the insulating material are, for example, a selective deposition (e.g. inkjet printing, screen printing, flexography) to avoid deposition at the center of the via hole or, as an alternative, a deposition over the entire area (e.g. by spin coating, blade coating, slot die coating, thermal evaporation, sputtering, chemical vapor deposition, atomic layer deposition, close space sublimation, pulsed laser deposition) followed by local ablations of the layers (e.g. by laser or mechanical ablation).

The deposition techniques that can be used for the supporting electrode are, by way of example but not exclusively, a selective deposition in the case of metal grids (e.g. by inkjet printing, silk-screen printing, flexography), or a deposition of metal layers over the entire area (e.g. by thermal evaporation, sputtering, electrodeposition) followed by possible ablations (e.g. by laser or mechanical ablation), or the electrode may be structured through a deposition mask.

The solution proposed with this invention can be applied to any type of thin film solar cell, such as perovskite solar cells, cells with cadmium tellurium, organic solar cells, cells with copper indium gallium selenium, cells with amorphous silicon, and all those cells wherein the light absorber is structured as a thin film on top of a substrate and is deposited between a lower (i.e. placed on the substrate) and an upper electrode.

In particular, for perovskite solar cells, the invention provides a method to avoid direct contact of the light absorbing material with the upper electrode, as would occur with standard interconnection. This role is played by the layer of insulating material.

Unlike existing solutions, the solution proposed according to the invention allows the addition of a lower supporting electrode above the device without inducing losses due to shading. Furthermore, the invention also allows the use of two supporting electrodes (in the form of grids) for the lower and upper electrodes. This solution is useful, as noted, for semi-transparent or bifacial devices, and is possibly carried out by overlapping the supporting electrodes. Furthermore, the present invention also provides a method for having a series connection across the supporting electrodes, as presented in the detailed description.

For the reasons set out above, the invention described here can be easily integrated into manufacturing processes and scaled up to large-area thin-film PV devices.

### Brief description of the drawings

The specific characteristics of the invention, as well as its advantages, will be more evident with reference to the accompanying figures, in which:

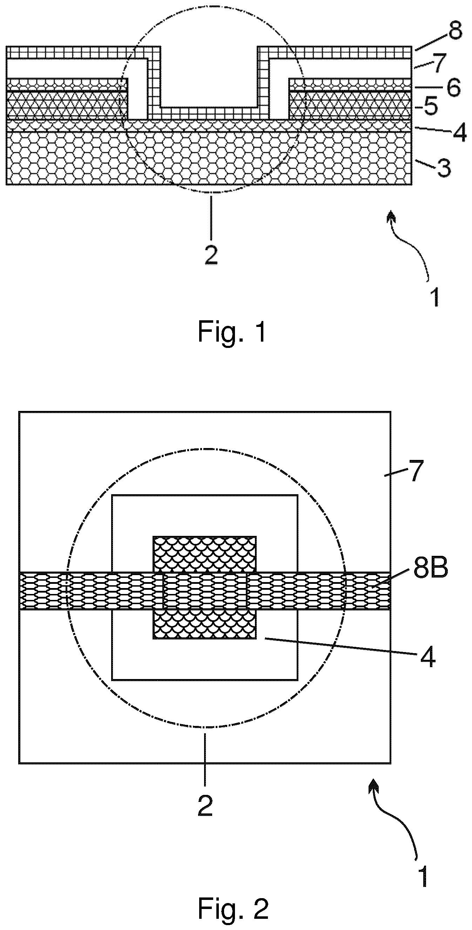

**Figure 1** is a schematic cross-section view of a portion of the photovoltaic device (1) according to a first embodiment of the invention, with a via hole (2); the structure of the device comprises a substrate (3), a lower electrode (4), a photoactive layer (5) consisting of an electromagnetic radiation absorber between two selective semiconductors, an upper electrode (6), an insulating layer (7), and a lower supporting electrode (8);
**Figure 2** is a schematic plan view of a portion of a photovoltaic device (1) according to another version of the first embodiment of the invention, with a via hole (2); the view shows a portion of the lower electrode (4), the specially shaped insulating layer (7) and a lower supporting electrode, represented in this version by a metal grid (8B);

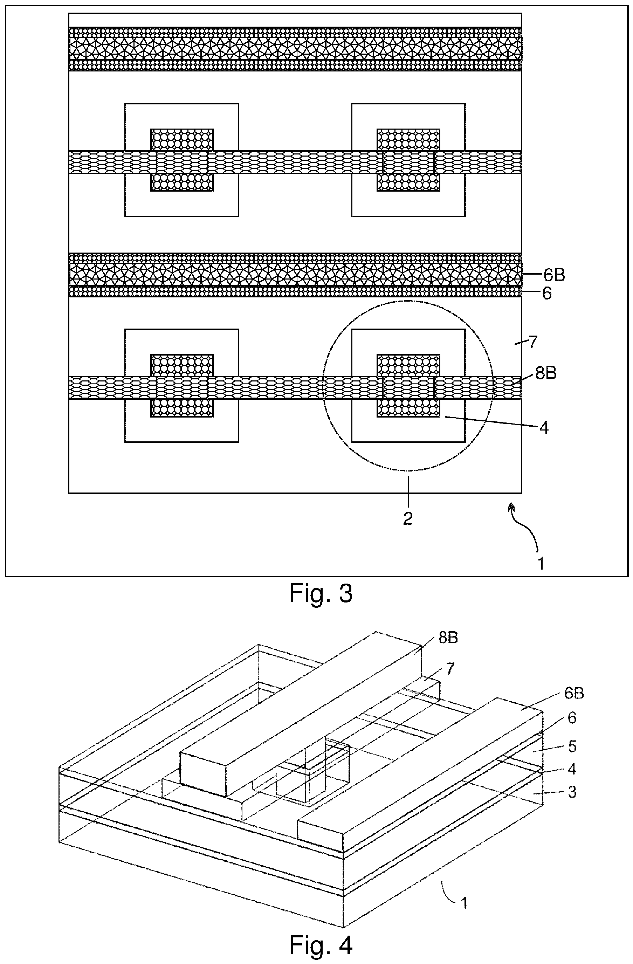

**Figure 3** is a schematic plan view of a portion of a photovoltaic device (1) according to a second embodiment of the invention, with a via hole (2) and two supporting electrodes, the view showing two couples of contiguous cells in series, with a lower electrode portion (4), an upper electrode portion (6), an upper supporting electrode in the form of a metal grid (6B), a specially shaped insulating layer (7) and a lower supporting electrode in the form of a grid (8B); in this embodiment, both supporting electrodes (6B and 8B) are in the form of a metal grid;
**Figure 4** shows a schematic perspective view of a portion of the second embodiment of the PV device (1) of Figure 3 which includes one via hole; the structure is formed by a substrate (3), a lower electrode (4), a photoactive layer (5) consisting of an electromagnetic radiation absorber between two selective semiconductors, an upper electrode (6), an upper supporting electrode in the form of a metal grid (6B), an insulating layer (7) and a lower supporting electrode in the form of a metal grid (8B);

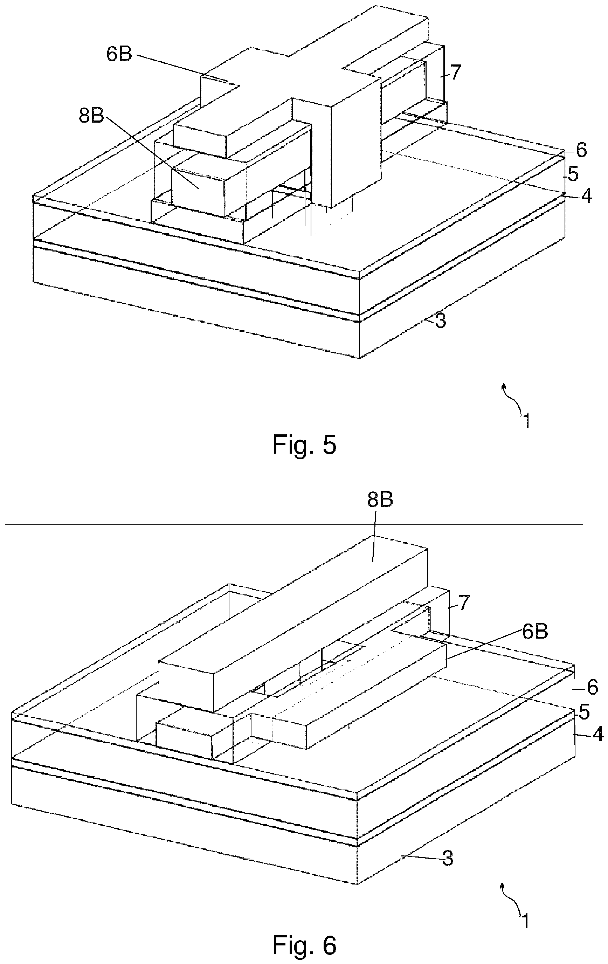

**Figure 5** shows a schematic perspective view of a portion of a PV device (1) according to a third embodiment of the invention, which includes one via hole and a superposition of supporting electrodes in the form of metal grids; the structure is formed by a substrate (3), a lower electrode (4), a photoactive layer (5) consisting of an electromagnetic radiation absorber between two selective semiconductors, an upper electrode (6), an upper supporting electrode in the form of a metal grid (6B), an insulating layer (7) and a lower supporting electrode in the form of a metal grid (8B);
**Figure 6** shows a schematic perspective view of a portion of a PV device (1) according to a fourth embodiment of the invention, which includes one via hole and a superposition of supporting electrodes in the form of metal grids; the structure is formed by a substrate (3), a lower electrode (4), a photoactive layer (5) consisting of an electromagnetic radiation absorber between two selective semiconductors, an upper electrode (6), an upper supporting electrode in the form of a grid metal (6B), an insulating layer (7) and a lower supporting electrode in the form of a grid (8B);

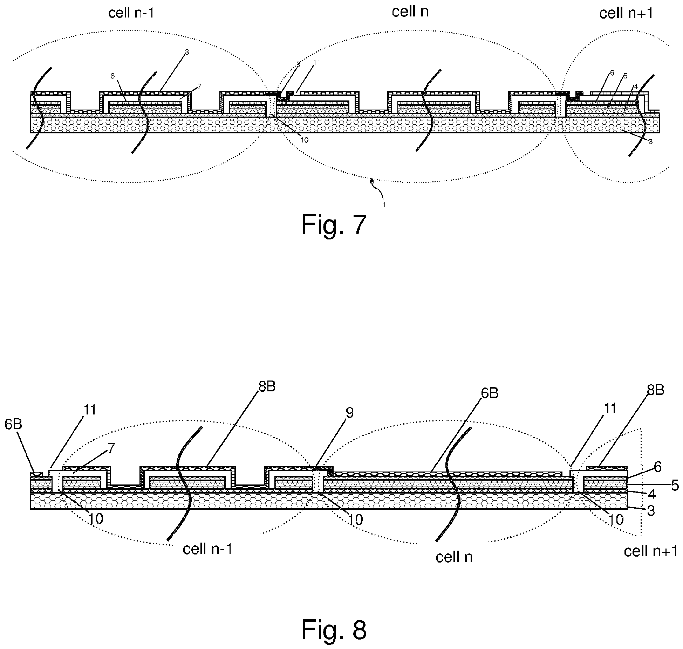

**Figure 7** is a schematic cross-section view of a monolithic series connection obtained using the first embodiment of the PV device (1); the structure of the device comprises a substrate (3), a lower electrode (4), a photoactive layer (5) consisting of an electromagnetic radiation absorber between two selective semiconductors, an upper electrode (6), an insulating layer (7) and a lower supporting electrode (8), a series connection area (9), a gap (10) in the lower and upper electrodes separating the two cells connected in series (e.g. cell n-1 and cell n) and a gap (11) in the lower supporting electrode;
**Figure 8** is a schematic cross-section view of a monolithic series connection obtained using the second embodiment of the PV device (1); the structure of the device comprises a substrate (3), a lower electrode (4), a photoactive layer (5) consisting of an absorber of electromagnetic radiation between two selective semiconductors, an upper electrode (6), an upper supporting electrode in the form of a metal grid (6B), an insulating layer (7), a lower supporting electrode in the form of a metal grid (8B), a series connection area (9), a gap (10) in the lower and upper electrodes) separating the two cells connected in series (e.g. cell n-1 and cell n) and a gap (11) in the lower supporting electrode;

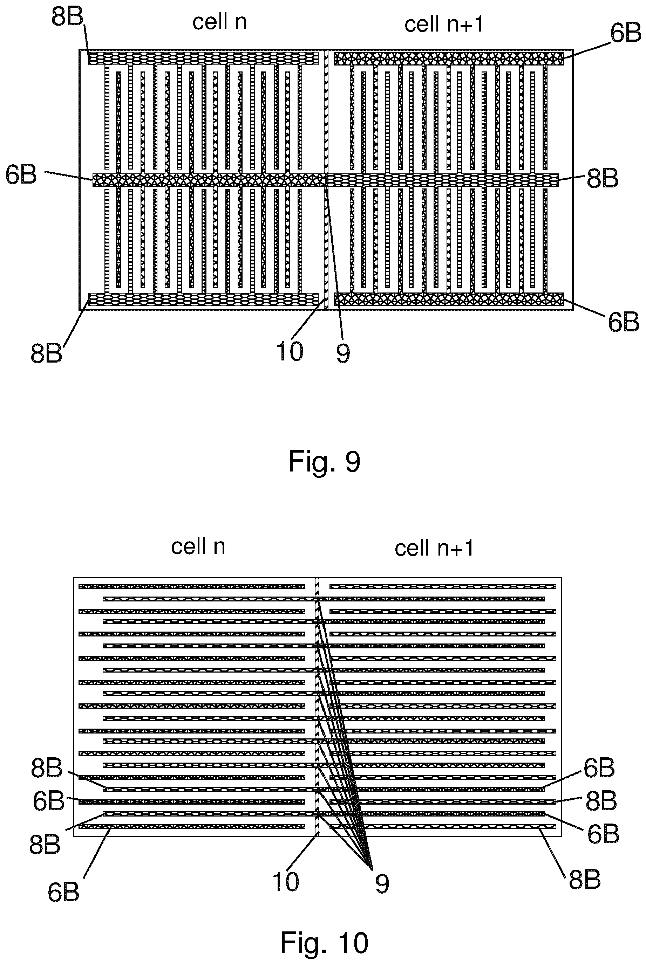

**Figure 9** is a schematic plan view of the shape of the supporting electrodes according to the second embodiment of the invention, in the configuration with busbar, which includes an upper supporting electrode (6B) in the form of a metal grid, a lower supporting electrode (8B) in the form of a metal grid, a series connection area (9), a gap (10) in the lower and upper electrodes separating the two series-connected cells (e.g. cell n and cell n+1) - the via holes distributed under the lower supporting electrode (8B) being not shown; and
**Figure 10** is a schematic plan view of the shape of the supporting electrodes according to the second embodiment of the invention, in the configuration without busbar, which includes an upper supporting electrode (6B) in the form of a metal grid, a lower supporting electrode (8B) in the form of a metal grid, a series connection area (9), an gap (10) in the lower and upper electrodes separating the two cells connected in series (e.g. cell n and cell n+1) - the via holes distributed under the lower supporting electrode (8B) being not shown.

### Detailed description of the invention

The present invention specifically concerns, therefore, a thin film photovoltaic device composed of photovoltaic cells in series, in which the cells are formed by depositing in sequence, on a substrate transparent to solar radiation,
a first transparent conductive electrode on said transparent substrate,
a photoactive layer consisting of an electromagnetic radiation absorbing layer between two layers of selective semiconductors, and
a second conductive electrode, preferably also transparent,
the device being characterized in that it comprises a first metal supporting electrode which is in contact with said first electrode of each cell through a via hole, the via holes being distributed over the area of the device.

Preferably, according to the invention, each via hole is made up of the following components:
a) an opening in the photoactive layer and in the second conductive electrode;
b) a layer of insulating material only on the sides of the opening a) which extend on top of said first conductive electrode;
c) a first metal supporting electrode deposited on top of the layer of insulating material b), which electrically contacts said first conductive electrode at the center of the opening a), where the layer of insulating material b) is not present.

Even more preferably, according to the present invention, said second conductive electrode is also transparent, and each cell further comprises a second supporting electrode, which contacts the second transparent electrode in openings of the layer of insulating material b), outside openings a).

Other characteristics of the thin film photovoltaic device of the present invention are set forth in the further dependent claims.

Preferably, according to the invention, the materials that can be used for the supporting electrodes can be thin layers of metal (such as for example Cu, Ag, Ni, Cr, Al), or thicker metal grids (for example of Cu, Ag, Ni, Cr, Al). According to further preferred solutions, the materials that can be used for the insulating layers are chosen from polymeric insulating materials (e.g. UV-curable) or metal oxides (such as alumina, zirconia and silica).

In detail, the first embodiment of the present invention, shown in Figures 1 and 2, consists in the use of via holes (2) in the structure of thin film PV devices (1). The structure of the device is made up by a substrate (3), a lower electrode (4), a photoactive layer (5) consisting of an electromagnetic radiation absorber between two selective semiconductors, an upper electrode (6), a layer of insulating material (7), and a lower (i.e. first) supporting electrode (8) . The structure is designed to allow contact between the lower supporting electrode (8) and the lower electrode (4).

The light absorbing material may be, for example, a metal-halogen hybrid perovskite layer, a cadmium tellurium layer, a copper indium gallium selenium layer, an amorphous silicon layer, an organic semiconductor heterojunction, or a III-V semiconductor layer, like gallium arsenide. The perovskite used for solar cells is a material with a perovskite crystal structure and chemical formula ABX₃ in which: A is a cation such as methylammonium (MA), formamidinium (FA), cesium (Cs), rubidium (Rb), potassium (K) or other monovalent cations, or a combination thereof; B is a divalent metal such as lead (Pb), tin (Sn) or others, or a combination thereof; C is an anion, most commonly a halogen such as Iodine (I), bromine (Br), chlorine (CI), but is not limited to these and can be a combination thereof.

The via holes (2) are repeated periodically on the surface of the device (1). Their shape in plan view can be, for example, square, circular, hexagonal or rectangular. The area covered by the via holes depends on the contact resistance between the lower electrode and the supporting electrode, while their distance depends on the conductivity of the electrodes. The periodic pattern can be regular (e.g. square or hexagonal lattice) to minimize resistive losses, or based on drawings to change the aesthetics of the device.

The fabrication of the structure according to the invention can be obtained through different methods, all divided into three steps: step 1 - deposition of the layers and opening of the via holes; step 2 - deposition and definition of the insulating layer; step 3 - deposition of the supporting electrodes. The manufacturing processes that can be used for step 1 are, by way of example but not exclusively:
- Option 1: All layers from the lower electrode (4) to the upper electrode (6) are deposited over the entire area of the substrate (3). The layers can be deposited from solution (e.g. inkjet printing, screen printing, rotogravure, flexography, spin coating, blade coating, slot die coating) or by vacuum techniques (e.g. thermal evaporation, sputtering, chemical vapor deposition, atomic layer deposition, close space sublimation, pulsed laser deposition). Subsequently, the photoactive layer (5) and the upper electrode (6) are removed by laser or mechanical ablation in the areas of the via holes. A portion of the lower selective layer which is part of the photoactive layer (5) may not be completely removed, if this does not affect the quality of the contact resistance between the lower electrode (4) and the lower (first) supporting electrode (8, 8A)).
- Option 2: after the deposition of the lower electrode (first transparent conductive electrode (4)) over the entire area of the substrate (3), the subsequent layers are selectively deposited on the areas not affected by the via holes. The layers can be deposited from solution or by vacuum techniques. For solution techniques it is possible to use graphic printing (e.g. inkjet printing, screen-printing, rotogravure, flexography) or printing techniques on the entire area (e.g. spin coating, blade coating, slot die coating) after having deposited a surface modifier that reduces wettability in the via holes areas (2). The surface modifier will prevent deposition in those areas. The materials that can be used are, by way of example but not exclusively, silicones or fluorinated materials. For vacuum deposition it is possible to use deposition masks or lithographic masks. For some techniques, such as chemical vapor deposition, atomic layer deposition, it is also possible to deposit a growth inhibitor in the areas of the via holes (2). It is also possible to deposit the lower selective layer, which is part of the photoactive layer (5) over the entire area, if this does not affect the quality of the contact resistance between the lower electrode (4) and the lower supporting electrode (8).

The manufacturing processes that can be used for step 2 are, by way of example but not exclusively:
- Option 1: The insulating layer (7) is placed over the entire area of the device and treated according to its formulation. The insulation can be deposited from solution (e.g. inkjet printing, screen printing, rotogravure, flexography, spin coating, blade coating, slot die coating) or by means of vacuum techniques (thermal evaporation, sputtering, chemical vapor deposition, atomic layer deposition, close space sublimation, pulsed laser deposition), followed by a laser or mechanical ablation in the internal area of the through contact. The ablation can be assisted by leaving part of the photoactive layer and the upper electrode in a portion of the internal area of the via hole in step 1. This can promote a cleaner ablation by leaving an insulating layer on the sides of the via hole that covers the photoactive layer (5) and the upper electrode (6).
- Option 2: The insulating layer (7) is selectively deposited, leaving openings in the central parts of the via holes (2). The insulating material can be deposited from solution or by vacuum techniques. For solution techniques it is possible to use graphic printing (e.g. inkjet printing, screen-printing, rotogravure, flexography) or printing techniques on the entire area (e.g. spin coating, blade coating, slot die coating) after having deposited a surface modifier to reduce wettability in the internal areas of the via holes (2). The surface modifier will prevent deposition in those areas. The materials that can be used are, by way of example but not exclusively, silicones or fluorinated materials. For vacuum deposition it is possible to use deposition masks or lithographic masks. For some techniques, such as chemical vapor deposition, atomic layer deposition, it is also possible to deposit a growth inhibitor in the internal areas of the via hole (2), which avoids the deposition of the insulating material.

The manufacturing processes which can be used for step 3 are, for example, thermal evaporation, sputtering, chemical vapor deposition, atomic layer deposition, close space sublimation, pulsed laser deposition of thin layers of metal. For thicker layers it is also possible to use printing techniques (e.g. screen printing or inkjet) of conductive pastes made, for example but not exclusively, of silver, copper or carbon-based materials (e.g. graphite paste ).

The metal layer can also be deposited by electrodeposition after having deposited a conductive agent on the interested layers. The lower supporting electrode can be deposited over the entire area or only on a portion thereof (always covering all the through holes). For example, Figure 2 shows how a metal grid can be used as first supporting electrode (8B).

In the second embodiment of the present invention, shown in Figures 3 and 4, a double supporting electrode is used to increase the conductivity of both the lower and upper electrodes. This is necessary for devices that use poorly conductive transparent electrodes (e.g. electrodes based on conductive oxides or polymers) both as the bottom (first) electrode (4) and as the top (second) electrode (6). To allow the introduction of an upper (second) supporting electrode (6B) the insulating layer (7) must be defined to expose part of the top electrode as shown in Figure 3. The manufacturing methods for fabricating the structure described in the second example embodiment are the same as described for the first example embodiment. In the second embodiment, both supporting electrodes must be defined to avoid short circuits between them: this can be achieved either by using two printed grids (as in Figures 3 and 4) or by depositing a single electrode over the entire area followed, by a laser or mechanical ablation to open a split between the two supporting electrodes.

When the two supporting electrodes are composed of metal grids, it is possible to choose among different arrangements in the way in which these are manufactured, as shown for example in Figures 4, 5 and 6. In the simplest example, relating to the second embodiment of the present invention, shown in Figure 4, the supporting electrodes are parallel to each other. However, in semi-transparent or bifacial devices, where it is important to minimize the shadowing due to the electrodes, it is advantageous to overlap the supporting electrodes using an insulating layer to avoid short circuits, as shown in Figures 5 and 6. These figures relate, respectively, to the third and to the fourth embodiment of the invention. The PV device (1) according to the third embodiment (Figure 5) can be created by depositing the lower supporting electrode (8B), covering it with an additional of insulating layer (7) and depositing the upper supporting electrode (6B) on top of it. The latter would also extend outside the insulating layer to contact the upper electrode (6), thus obtaining the structure shown in Figure 5. The PV device (1) according to the fourth embodiment (Figure 6) can be obtained by first depositing the upper supporting electrode (6B) with a pattern that leaves space in via hole, followed by the addition of an insulating layer (7), and the fabrication of the lower supporting electrode (8B).

Although the invention described allows the width of each cell to be greatly enlarged, it may still be advantageous to add some series connections to increase the voltage of the PV device (1). The present invention allows freedom in designing the width of the cells, since it allows the conductivity of the electrode to be adjusted.

With reference to the interconnection between cells, Figure 7 shows how a series connection can be implemented in the case of the first embodiment of the invention, having only the first supporting electrode. Compared to individual cells, the interconnected PV device (1) requires openings (10) in the lower (4) and upper (6) electrodes to electrically separate the two cells to be connected in series (cell n-1 and cell n). The opening can be created, for example, at the end of the deposition of the upper electrode, by laser or mechanical ablation, and is subsequently filled with the same insulating layer (7) used for the via holes. Furthermore, the insulation must be shaped to allow direct contact (9) between the lower supporting electrode (8) of one cell (i.e., cell n-1) and the upper electrode (6) of the next (i.e., cell n). Finally, the supporting electrode (8) must be shaped to leave an opening (11) between the contact (9) and the first via hole of the cell (cell n) used to make the contact (9). In this way, the lower electrode (4) of one cell (cell n-1) will be interconnected with the upper electrode (6) of the next (cell n), as required by the series connection.

Figure 8 instead shows how to make a series connection in the case of the second embodiment of the invention, with two supporting electrodes. As in the previous case, there is a need for an opening (10) in the lower (4) and upper (6) electrodes, to electrically separate the two cells to be connected in series (cell n-1 and cell n). The opening can be created, for example, at the end of the deposition of the upper electrode by laser or mechanical ablation, and is subsequently filled with the same insulating layer (7) used for the via holes. The series connection (9) can be obtained over the insulating layer covering the opening (10), by structuring the supporting electrodes and via holes so that a supporting electrode acts as a lower supporting electrode for a cell (cell n-1) (therefore entering the via holes) and as an upper supporting electrode for the next cell (cell n) (therefore not entering the via holes). Also in this case, it is necessary to provide an opening (11) in the supporting electrodes to prevent the upper supporting electrode of one cell (cell n-1) from coming into contact with the lower supporting electrode of the next (cell n).

When large area devices make use of multiple supporting electrodes interconnected in series, the design of the electrodes may or may not include the presence of busbars. The latter are present in Figure 9 but not in Figure 10. The choice between the two options will depend on the geometry and conductivity of the supporting electrodes: as for silicon cells, busbars will be necessary if there is a need to increase the length of the cells as much as possible, but they can be avoided if the width of the cells is a few centimeters.

The present invention has been disclosed with particular reference to some specific embodiments thereof, but it should be understood that modifications and changes may be made to it by the persons skilled in the art without departing from the scope of protection as defined in the claims.

## Claims

1. A thin film photovoltaic device composed of photovoltaic cells in series, in which the cells are formed by depositing in sequence, on a substrate (3) transparent to solar radiation,
a first transparent conductive electrode (4) on said transparent substrate,
a photoactive layer (5) consisting of an electromagnetic radiation absorbing layer between two layers of selective semiconductors, and
a second conductive electrode (6), preferably also transparent,
the device being **characterized in that** it comprises a first metal supporting electrode (8, 8B) which is in contact with said first electrode (4) of each cell through a via hole (2), the via holes being distributed over the area of the device.

2. The thin film photovoltaic device according to claim 1, wherein each via hole (2) is formed by the following components:
a) an opening in the photoactive layer (5) and in the second conductive electrode (6);
b) a layer of insulating material (7) only on the sides of the opening a) which extend on top of said second conductive electrode (6);
c) a first metal supporting electrode (8, 8B) placed on top of the layer of insulating material (7), which electrically contacts said first conductive electrode (4) at the center of the opening a), where the layer of insulating material (7) is not present.

3. The thin film photovoltaic device according to claim 2, wherein said second conductive electrode (6) is also transparent.

4. The thin film photovoltaic device according to claim 3, wherein each cell further comprises a second supporting electrode (6B), which contacts said second transparent electrode (6) in openings of the layer of insulating material (7), outside the openings a).

5. The thin film photovoltaic device according to claim 4, wherein there is a partial overlap between said first supporting electrode (8B) and said second supporting electrode (6B), which electrodes are separated by a layer of insulating material (7).

6. The thin film photovoltaic device according to any one of claims 1-5, wherein a series connection with the following characteristics is further provided:
i. an opening (10) in said first electrode (4), in the photoactive layers (5) and in said second electrode (6), filled with the same insulating material (7);
ii. an opening (9) in said layer of insulating material (7) downstream the opening (10), where said first supporting electrode (8B) of one cell contacts said second electrode (6B) of the next cell;
iii. an opening (11) in said first supporting electrode (8B) downstream the opening (9).

7. The thin film photovoltaic device according to any one of claims 2-5, wherein a series connection with the following characteristics is further provided:
i. an opening (10) in said first electrode (4), in the photoactive layers (5) and in said second electrode (6), filled with the same insulating material (7);
ii. a first supporting electrode (8B) of a cell extending extends onto the next one becoming the second supporting electrode (6B) (9);
iii. an opening (11) in said second supporting electrode (6B) of the first cell configured to prevent said electrode from being in contact with the first supporting electrode (8B) of the next cell.
